(19) Europäisches Patentamt
European Patent Office
Office européen des brevets

(11) Veröffentlichungsnummer: **0 272 558**
**A2**

# (12) EUROPÄISCHE PATENTANMELDUNG

(21) Anmeldenummer: **87118398.4**

(22) Anmeldetag: **11.12.87**

(51) Int. Cl.4: **C08G 59/68** , C08L 63/00 , C09J 3/16

(30) Priorität: **19.12.86 DE 3643400**

(43) Veröffentlichungstag der Anmeldung:
**29.06.88 Patentblatt 88/26**

(84) Benannte Vertragsstaaten:
**AT BE CH DE ES FR GB GR IT LI LU NL SE**

(71) Anmelder: **Henkel Kommanditgesellschaft auf Aktien**
**Postfach 1100 Henkelstrasse 67**
**D-4000 Düsseldorf-Holthausen(DE)**

(72) Erfinder: **Artiga Gonzales, René-Andrés, Dr.**
**Bilker Allee 10**
**D-4000 Düsseldorf(DE)**
Erfinder: **Nicolaisen, Heinz-Christian**
**Ossietzkyring 4**
**D-3000 Hannover(DE)**
Erfinder: **Ruhnke, Anja**
**Bogenstrasse 58**
**D-4018 Langenfeld(DE)**

## (54) Verfahren zum Kleben nichttransparenter Substrate und dazu verwendbare Klebesysteme.

(57) Die Erfindung betrifft ein Verfahren zum Kleben fester Substrate unter Verwendung von Epoxidharz, Photoinitiator und gegebenenfalls Photosensibilisator enthaltenden, nach Polymerisation klebend wirkenden Mischungen, das dadurch gekennzeichnet ist, daß man eine Klebemischung aus einem oder mehreren epoxidischen Monomeren, einem unter Einwirkung elektromagnetischer Strahlung Protonen freisetzenden Photoinitiator und gegebenenfalls einem Photosensibilisator herstellt, diese auf die zu verklebenden Substratflächen aufträgt, eine Polymerisation der Klebemischung durch Bestrahlung mit elektromagnetischer Strahlung einleitet, die Polymerisation bis kurz vor den Gelpunkt des Polymeren führt, die zu verklebenden und mit Klebemischung beschichteten Substratflächen vereinigt und die verklebende Polymermischung aushärtet, sowie im genannten Verfahren verwendbare Klebesysteme, die ein oder mehrere epoxidische Monomere, einen unter Einwirkung elektromagnetischer Strahlung Protonen freisetzenden Photoinitiator und gegebenenfalls einen Photosensibilisator enthalten.

EP 0 272 558 A2

Xerox Copy Centre

## Verfahren zum Kleben nichttransparenter Substrate und dazu verwendbare Klebesysteme

Die Erfindung betrifft ein Verfahren zum Kleben nichttransparenter Substrate und in diesem Klebeverfahren verwendbare Klebesysteme.

Unter den zusammenfassenden Namen "Reaktivklebstoffe" fallen neben Vinylmonomere enthaltenden und in Gegenwart von Metallsalzen oxidativ härtbaren Klebstoffmischungen auch solche Klebstoffe, die Epoxidharze in Abmischungen mit Härtern wie Polyaminen, Polyaminoamiden, Polymercaptanen und Säureanhydriden enthalten und die im Einsatz für heißhärtende und kalthärtende Klebstoffe mehr und mehr an Bedeutung gewinnen. Im Regelfall werden als Epoxidharzkomponente für derartige Epoxidharz-Reaktivkleber flüssige Glycidylether auf Basis von Diphenylolpropan mit Epoxidäquivalentgewichten zwischen 170 und 300 bevorzugt eingesetzt. Derartige Mischungen sind beispielsweise in "Ullmanns Encyclopedia of Industrial Chemistry", Vol. A1, Seite 230 bis 241, VCH-Verlagsgesellschaft, beschrieben.

Unter "Epoxidäquivalentgewicht" wird hier wie in der folgenden Beschreibung und in den Patentansprüchen diejenige Menge an Epoxidharz (in g) verstanden, die ein Äquivalent an Epoxidgruppen enthält. So wird beispielsweise unter einem Epoxidäquivalentgewicht von 170 verstanden, daß 170 g eines Epoxidgruppen enthaltenden Harzes ein Äquivalent an derartigen epoxidischen Gruppen enthält.

Die Methode der durch Licht initiierten kationischen Polymerisation von Epoxiden ist seit langer Zeit bekannt und in der Technik in vielfacher Weise variiert worden. Zusammenfassend berichtete darüber J. Crivello in "Advances in Polymer Science" 62 , 3 (1984). In dieser Druckschrift werden als geeignete Photoinitiatoren, d.h. Verbindungen, die nach Bestrahlung mit Licht Protonen freisetzen und dadurch die Polymerisation von Epoxiden zu initiieren vermögen, organische Sulfonium-, bzw. Jodoniumsalze genannt, die sich in der Technik mehr oder weniger gut bewährt haben.

Jodoniumsalze als Bestandteile photopolymerisierbarer Zusammensetzungen mit säurepolymerisierbaren oder säurehärtbaren Materialien werden auch in der DE-OS 26 02 574 beschrieben. In den als Photoinitiator in derartigen Zusammensetzungen beschriebenen Jodoniumsalzen sind die organischen Reste gleich oder unterschiedlich substituierte Phenylreste. Die in der genannten Druckschrift beschriebenen Zusammensetzungen sind (vgl. Seite 12, letzte Zeile und Seite 13, erster Absatz), neben anderen Anwendungszwecken, auch als Kleber für solche Substrate brauchbar, die "in situ bestrahlt werden können, beispielsweise bei der Bildung von Schichtkörpern oder Laminaten, wo eine Lage oder Schicht oder beide strahlungsdurchlässig ist bzw. sind". Dies bedeutet aber nichts Anderes, als daß die in der genannten Druckschrift beschriebenen Zusammen setzungen nur solche Substrate vollständig zu verkleben vermögen, von denen mindestens eines die für die Initiation und Weiterführung der Polymerisationsreaktion erforderliche Strahlung durchläßt. Für die erforderliche Strahlung nicht durchlässige Substrate können mit den beschriebenen Zusammensetzungen nicht verklebt werden; dies stellt einen der gravierendsten Nachteile der ansonsten durchaus auch als Kleber brauchbaren Zusammensetzungen dar.

Komplexe, aromatische Substituenten enthaltende Sulfoniumsalze als Photoinitiatoren zur Polymerisation von epoxidischen Monomeren, die sich zu Filmen oder Überzügen polymerisieren lassen, werden in den Druckschriften DE-OS 29 04 450 und US-PS 4 173 476 beschrieben. Abgesehen davon, daß die Triarylsulfonium-Komplexsalze als Photoinitiatoren enthaltenden epoxidischen Massen wegen ihrer niedrigen Viskosität als Klebstoff kaum verwendbar sind, besteht ein gravierender Nachteil der beschriebenen Zusammensetzungen darin, daß die einmal initiierte Vernetzungsreaktion mit so hoher Geschwindigkeit verläuft, daß die beschichteten Werkstoffe nicht mehr sicher an den gewünschten Stellen fixiert werden können.

Epoxidgruppenhaltige Verbindungen enthaltende, mit Hilfe eines Photoinitiators polymerisierbare Systeme werden auch in den Druckschriften EP-A-0 119 425 und EP-A-0 118 044 beschrieben. Die genannten Epoxidzusammensetzungen sind jedoch nicht dazu geeignet, nichttransparente Substrate zu verkleben, da sie zu Festigkeiten der miteinander verklebten Substrate führen, die weit hinter den erwünschten Werten zurückbleiben. So werden beispielsweise bei metallischen Substraten nur Scherfestigkeiten unter 1 N . mm $^{2}$ gefunden. Dies kann darauf zurückgeführt werden, daß die ausgehärteten Klebstoffilme in der Fuge aufgrund ihrer schlechten Affinität zu metallischen Oberflächen nur Adhäsionseigenschaften besitzen, so daß keine für praktische Zwecke ausreichende Verklebung eintritt.

Die Erfindung stellte sich zur Aufgabe, ein Verfahren zur Verfügung zu stellen, mit dem nicht nur transparente, sondern auch nichttransparente Substrate, wie beispielsweise metallische Werkstoffe, im Rahmen einer durch Licht initiierten Polymerisation epoxidischer Monomerer verklebt werden können. Dabei sollte insbesondere sichergestellt werden, daß die Polymerisationsreaktion durch Licht geeigneter Wellenlängen initiiert werden kann, jedoch die kationische Polymerisationsreaktion nach einmaliger Initiierung auch im Dunkeln, beispielsweise im Dunkeln der Klebefuge, weiter voranschreitet und damit eine

Verklebung auch ohne weitere Bestrahlung erfolgen kann. Die im Rahmen dieses Verfahrens verwendbaren Klebesystme sollten eine für die praktische Anwendung zufriedenstellende, hohe Viskosität aufweisen, wobei die Quantenausbeute gegenüber bisher bekannten Systemen verbessert und auch die Transmission für das zur Initiierung der Polymerisation verwendete Licht verbessert werden sollte. Weiterhin sollte gewährleistet werden, daß mit dem Klebeverfahren eine Festigkeit der Verklebung erreicht werden kann, die zumindest im Bereich bisher bekannter Festigkeiten, gemessen beispielsweise als Zugscherfestigkeiten oberhalb N . mm $^{2}$ , liegen sollte.

Überraschend wurde nun gefunden, daß man nicht nur optimale Ergebnisse in der Verklebung fester Substrate erzielen, sondern auch die oben genannten Nachteile aus dem Stand der Technik vermeiden kann, wenn man bei Verwendung von Epoxidharz, Photoinitiator und gegebenenfalls Photosensibilisator enthaltenden Klebemischungen nach der Initiation der Polymerisation durch Bestrahlung mit elektromagnetischer Strahlung die Polymerisation einleitet, danach die zu verklebenden Substratflächen vereinigt und die verklebende Polymermischung nach Vereinigung aushärten läßt.

Die Erfindung betrifft ein Verfahren zum Kleben fester Substrate unter Verwendung von Epoxidharz, Photoinitiator und gegebenenfalls Photosensibilisator enthaltenden, nach Polymerisation klebend wirkenden Mischungen, das dadurch gekennzeichnet ist, daß man eine Klebemischung aus einem oder mehreren epoxidischen Monomeren, einem unter Einwirkung elektromagnetischer Strahlung Protonen freisetzenden Photoinitiator und gegebenenfalls einem Photosensibilisator herstellt, diese auf die zu verklebenden Substratflächen aufträgt, eine Polymerisation der Klebemischung durch Bestrahlung mit elektromagnetischer Strahlung einleitet, die zu verklebenden und mit Klebemischung beschichteten Substratflächen vereinigt und die verklebende Polymermischung aushärtet. Zweckmäßig läßt man die Polymerisation bis kurz vor den Gelpunkt des Polymeren fortschreiten.

Die Erfindung betrifft außerdem in dem genannten Verfahren verwendbare Klebesysteme, die ein oder mehrere epoxidische Monomere, einen unter Einwirkung elektromagnetischer Strahlung Protonen freisetztenden Photoinitiator und gegebenenfalls einen Photosensibilisator enthalten.

Unter "Photoinitiatoren" werden hier wie in der nachfolgenden Beschreibung und in den Patentansprüchen Verbindungen verstanden, die durch Belichtung mit elektromagnetischer Strahlung, die im ultravioletten, aktinischen oder sichtbaren Bereich des Spektrums liegen kann, Protonen entwickelt und damit eine Polymerisationsreaktion, die durch Protonen in Gang gesetzt werden kann, zu initiieren vermag.

Unter "Photosensibilisatoren" werden hier wie in der nachfolgenden Beschreibung und in den Patentansprüchen solche Substanzen verstanden, die besonders leicht vom Singlett-in den Triplett-Zustand übergehen können, d.h. aus einem bestimmten Strahlungsbereich des elektromagnetischen Spektrums Energie absorbieren können, diese auf ein anderes Molekül zu übertragen in der Lage sind und dabei selbst in den energetischen Grundzustand zurückkehren.

In dem erfindungsgemäßen Verfahren zum Kleben fester Substrate werden primär aus unterschiedlichen Komponenten bestehende Mischungen hergestellt, die im Zustand der Mischung vor der Polymerisation keine Klebewirkung aufweisen, jedoch nach Initiierung der Polymerisation durch Licht und mehr oder weniger weit fortgeschrittener Polymerisation klebend wirken und dadurch in der Lage sind, feste Substrate unter Ausbildung einer Werkstoffschicht der Klebemischung zu verbinden. Erfindungsgemäß stellt man primär Klebemischungen her, die aus einem oder mehreren epoxidischen Monomeren sowie einem unter Einwirkung elektromagnetischer Strahlung Protonen freisetzenden Photoinitiator bestehen. Gegebenenfalls ist es möglich, den im ersten Schritt des Verfahrens hergestellten Klebe mischungen auch einen Photosensibilisator zuzusetzen; dies ist insbesondere dann als wünschenswert anzusehen, wenn als elektromagnetische Strahlung zur Initiierung der polymerisation natürliches Licht oder Licht bestimmter Wellenlängen verwendet werden soll, die im sichtbaren Bereich liegen, und dieses Licht nicht oder zumindest nicht optimal in der Lage ist, den Photoinitiator zur Bildung einer ausreichenden Menge an Protonen anzuregen, die die Polymerisationreaktion initiieren könnten.

In einer bevorzugten Ausführungsform des erfindungsgemäßen Verfahrens setzt man eine Mischung von wenigstens zwei Epoxidharzen ein, wobei eine als niedermolekulare, wenigstens trifunktionelle Epoxidverbindung den Aufbau eines dreidimensionalen Netzwerkes ermöglicht. In der Praxis werden mit besonderem Vorteil solche Mischungen von Epoxidharzen verwendet, die epoxidische Derivate des Diphenylolpropans sind. Dabei sind insbesondere solche epoxidischen Derivate bevorzugt und können vorteilhafte Klebemischungen mit ausgezeichneten Klebeergebnissen ergeben, deren mittlere Molekulargewichte zu Epoxidäquivalenten von 150 bis 300 führen.

Als weitere epoxidische Monomerkomponente der in dem erfindungsgemäßen Verfahren verwendeten Klebemischungen, die einen raschen Aufbau eines dreidimensionalen Netzwerks ermöglichen, werden Gylcidylether mehrwertiger Hydroxyverbindungen verwendet, wobei dem Triglycidylether des Glycerins und/oder des Trimethylolpropans besondere Bedeutung zukommt.

Angestrebt und damit besonders bevorzugt im Sinne der vorliegenden Erfindung ist eine Viskosität der Klebemischungen, die - nach Brookfield bei 25°C gemessen -im Bereich zwischen 7 000 und 50 000 mPas liegt.

Als zweite Komponente der in dem erfindungsgemäßen Verfahren im Primärschritt hergestellten Klebemischungen wird ein unter Einwirkung elektromagnetischer Strahlung Protonen freisetzender Photoinitiator verwendet. Unter "elektromagnetischer Strahlung" wird dabei prinzipiell der gesamte Wellenlängenbereich verstanden, in dem sich üblicherweise die elektromagnetische Strahlung bewegen kann, die zur Initiation einer Photopolymerisation praktisch eingesetzt werden kann. Dieser Bereich liegt üblicherweise bei 200 bis 700 nm. In einer bevorzugten Ausführungsform des erfindungsgemäßen Verfahrens wird eine Klebemischung verwendet, die als Photoinitiator eine Substanz enthält, die unter Einwirkung elektromagnetischer Strahlung im Wellenlängenbereich von 200 bis 600 nm anregbar ist.

In der Praxis haben sich als Photoinitiator-Komponente der in dem erfindungsgemäßen Verfahren verwendeten Klebemischungen Verbindungen aus der Gruppe der Triarylsulfoniumsalze der allgemeinen Formel (I)

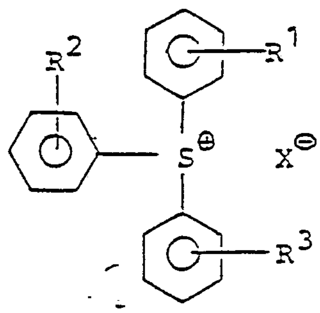

(I)

oder der Diaryljodoniumsalze der allgemeinen Formel (II)

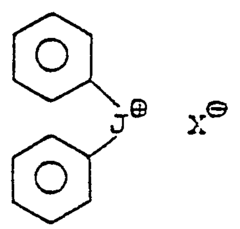

(II)

bewährt. In der oben genannten allgemeinen Formel (I) sind die Reste $R^1$, $R^2$ und $R^3$ gleich oder verschieden und stehen unabhängig voneinander für Wasserstoff, eine Nitrogruppe, ein Halogenatom, Oxalkyl- oder Thioalkylgruppen mit 1 bis 6 C-Atomen im geradkettigen oder verzweigten Alkylrest, substituierte oder unsubstituierte Phenoxygruppen mit 1 bis 3 Substituenten im Phenylrest oder Alkanoyl-oder Alkanolyamidoreste mit 1 bis 5 C-Atomen im Alkylrest der zugehörigen Carbonsäure. Außerdem ist es möglich, daß jeweils zwei der Reste $R^1$ und $R^2$ oder $R^2$ und $R^3$ als Methylengruppe, i-Propylengruppe oder Carbonylgruppe eine Brücke zwischen zwei benachbarten Phenylresten bilden und damit diese beiden Phenylreste zu einem heterocyclischen Ringsystem des Thioxanthens unter Bildung von Thioxantheniumionen verbinden. In der oben genannten allgemeinen Formel (I) steht $X^{\ominus}$ für ein halogenhaltiges komplexes Anion. In bevorzugten Ausführungsformen des erfindungsgemäßen Verfahrens werden Klebemischungen verwendet, in denen Photoinitiatoren aus der Gruppe solcher Ionen-Verbindungen gewählt werden, die der allgemeinen Formel (I) entsprechen, in denen $X^{\ominus}$ für komplexe Anionen aus der Gruppe Perchlorat, Tetrafluoroborat(III), Hexachloroantimonat(V), Hexafluoroantimonat(V), Hexachlorostannat(IV), Hexafluorophosphat, Hexafluoroarsenat(V), Tetrachloroferrat(III) und Pentachlorobismutat(III) steht.

In der oben genannten allgemeinen Formel (II), die für in dem erfindungsgemäßen Verfahren ebenfalls als Photoinitiator verwendbare Jodoniumsalze steht, haben die Reste $R^1$ und $R^2$, die gleich oder verschieden sein können, die gleiche Bedeutung, wie sie oben für die Verbindungen der allgemeinen Formel (I) angegeben wurde. $R^1$ und $R^2$ können also unabhängig voneinander für Wasserstoff, Nitrogruppen, Halogenatome, Oxalkyl-oder Thioalkylgruppen mit 1 bis 6 C-Atomen im geradkettigen oder verzweigten Alkylrest, substituierte oder unsubstituierte Phenoxygruppen mit 1 bis 3 Substituenten am Phenylrest oder Alkanoyloxy-oder Alkanoylamidoreste mit 1 bis 5 C-Atomen im Alkylrest der zugehörigen Carbonsäure stehen. In der angegebenen allgemeinen Formel (II) bedeutet das Anion $X^{\ominus}$ -wie auch oben für die

Verbindungen der allgemeinen Formel (I) angegeben -ein halogenhaltiges komplexes Anion, das in bevorzugten Ausführungsformen des erfindungsgemäßen Verfahrens und den darin verwendeten Klebemischungen beispielsweise für Perchlorat, Tetrafluoroborat(III), Hexachloroantimonat(V), Hexafluoroantimonat-(V), Hexachlorostannat(IV), Hexafluorophosphat, Hexafluoroarsenat(V), Tetrachloroferrat(III) oder Pentachlorobismutat(III) stehen kann.

Die oben definierten Reste $R^1$, $R^2$ und $R^3$ in den allgemeinen Formeln (I) und (II) können - wie angegeben-beispielsweise Oxalkyl-oder Thioalkylgruppen mit 1 bis 6 C-Atomen im geradkettigen oder verzweigten Alkylrest sein. Als Alkylreste der Oxalkyl-oder Thioalkylgruppen kommen somit Methyl, Ethyl, n-Propyl, n-Butyl, n-Pentyl oder n-Hexyl sowie die verzweigten Isomeren der genannten geradkettigen Alkylreste in Frage. Die Alkanoyloxy-oder Alkanoylamidoreste mit 1 bis 5 C-Atomen im Alkylrest der zugehörigen Carbonsäure können in bevorzugten Ausführungsformen des erfindungsgemäßen Verfahrens und den darin verwendeten Klebemischungen von Essigsäure, Propionsäure, Buttersäure, Valeriansäure oder Caprylsäure abstammen. $R^1$, $R^2$ oder $R^3$ können also unabhängig voneinander für Acetoyloxy-, Propionyloxy-, Butyryloxy-, Valeroyloxy-oder Caproyloxyreste oder die entsprechenden Amidoreste der genannten Carbonsäuren stehen. $R^1$, $R^2$ und $R^3$ können unabhängig voneinander auch für substituierte oder unsubstituierte Phenoxygruppen stehen, wobei -im Falle der Substitution - ein Phenoxyrest 1 bis 3 Substituenten tragen kann. Also solche Substituenten kommen in erster Linie Nitro-, Halogen-oder Alkylsubstituenten mit 1 bis 6 C-Atomen in Frage, wobei diese mit Vorteil aus der Gruppe Methyl, Ethyl, n-Propyl, n-Butyl, n-Pentyl und n-Hexyl sowie deren verzweigtkettigen Isomeren ausgewählt sind.

In der Praxis werden in dem erfindungsgemäßen Verfahren zum Kleben fester Substrate mit besonderem Vorteil Klebemischungen verwendet, in denen ein Photoinitiator aus der folgenden Gruppe der Verbindungen der allgemeinen Formeln (I) und (II) enthalten ist: Triphenylsulfoniumtetrafluoroborat, Triphenylsulfoniumhexafluorophosphat, Triphenylsulfoniumhexafluoroantimonat, Tritoluylsulfoniumhexafluorophosphat, Anisyldiphenylsulfoniumhexafluoroantimonat, 4-Butoxyphenyldiphenylsulfoniumtetrafluoroborat, 4-Chlorphenyldiphenylsulfoniumhexafluoroantimonat, tris-(4-Phenoxyphenyl-)sulfoniumhexafluorophosphat, 4-Acetoxyphenyldiphenylsulfoniumtetrafluoroborat, tris-(4-Thiomethoxyphenyl-)sulfoniumhexafluoroborat, 4-Acetaminophenyldiphenylsulfoniumtetrafluoroborat, 10-Phenylthioxanthenium hexafluorophosphat, 10-Phenyl-9,9-dimethylthioxantheniumhexafluorophosphat, 10-Phenyl-9-oxothioxantheniumtetrafluoroborat.

In einer besonders bevorzugten Ausführungsform des erfindungsgemäßen Verfahrens zum Kleben fester Substrate werden Klebemischungen verwendet, die zusätzlich zu den bisher genannten Komponenten, d.h. einer oder mehrerer oxidischer Monomerer und einem unter Einwirkung elektromagnetischer Strahlung Protonen freisetzenden Photoinitiator, auch einen Photosensibilisator enthalten. Dieser wird insbesondere dann eingesetzt, wenn man natürliches Licht, beispielsweise Sonnenlicht, oder auch Licht einer bestimmten Wellenlänge des sichtbaren Spektrums für die Initiierung der Polymerisation verwenden will. Der Photosensibilisator ist dann in der Lage, die eingestrahlte Lichtenergie auf den Photoinitiator zu übertragen, der seinerseits Protonen bildet und damit die Polymerisation in Gang setzt.

Als Photosensibilisatoren können mit besonderem Vorteil übliche Sensibilisatoren für den sichtbaren Bereich des elektromagnetischen Spektrums verwendet werden. Als solche sind aus dem Stand der Technik dem Fachmann Acridine, Perylene und Benzoflavine als bevorzugte Beispiele bekannt. Aus der Gruppe der genannten Verbindungen sind u.a. die unter dem Namen Acridin-orange, Acridin-gelb, Benzoflavin, Setoflavin T, Phosphin R und Perylen bekannten Verbindungen geeignet.

Die Mengenverhältnisse der drei genannten Komponenten der Klebemischungen können in weiten Bereichen variie ren. Als besonders vorteilhaft, d.h. nicht nur hinsichtlich der Viskosität der Ausgangsmischung, sondern auch hinsichtlich des Klebeergebnisses als besonders bevorzugt haben sich folgende Mengenverhältnisse herausgestellt: Die epoxidischen Bisphenol-A-Derivate werden üblicherweise in Mengen von 50 bis 99 Gew.-%, bezogen auf das Gesamtgewicht der Klebemischung, eingesetzt, wobei ein Bereich von 60 bis 80 Gew.-% besonders bevorzugt ist. Die niedermolekulare Epoxidverbindung, die für den raschen Aufbau eines dreidimensionalen Netzwerks als besonders bevorzugt verwendet wird, ist in Mengen von 0 bis 50 Gew.-% den erfindungsgemäßen Klebemischungen beizumischen, wobei ein Bereich von 10 bis 30 Gew.-% besonders bevorzugt ist. Der Photoinitiator ist in den für das erfindungsgemäße Verfahren geeigneten Klebemischungen in Mengen von 1 bis 5 Gew.-% zugegen, wobei eine Menge von 2 bis 3 Gew.-% besonders bevorzugt ist. Ein Photosensibilisator ist kein zwingender Bestandteil der für das erfindungsgemäße Verfahren geeigneten Klebemischungen. Er wird deswegen in Mengen von 0 bis 0,01 Gew-% den Klebemischungen zugesetzt. Mit derartigen Mischungen lassen sich in vorteilhafter Weise nicht nur schon vor der Polymerisation gute Anwendungseigenschaften, wie beispielsweise eine brauchbare Viskosität der Mischung, erzielen, diese liegt üblicherweise im optimalen Bereich von 7 000 bis 50 000 mPas, gemessen nach Brookfield bei 25°C. Vielmehr können mit solchen Klebemischungen bei Verwendung in dem erfindungsgemäßen Verfahren auch optimale Klebeergebnisse in der Verklebung fester

Substrate erzielt werden, wobei die Zugscherfestigkeiten oberhalb von 5 N . mm $^{2}$ liegen.

Der zweite Schritt des erfindungsgemäßen Verfahrens besteht darin, daß man die oben beschriebenen Klebe mischungen auf die zu verklebenden Substratflächen aufträgt. Bevorzugt ist es dabei, daß beide zu verklebenden Substratflächen mit der Klebemischung versehen werden. Dies geschieht üblicherweise dadurch, daß die hochviskose Masse auf die wie üblich vorbereiteten Substrate manuell mit einem Spatel oder mit Hilfe eines automatischen Auftragsystems aufgetragen wird. Die Schichtdicke der Klebemischung auf den beiden Substratflächen liegt - zweckmäßig - im Bereich zwischen 0,5 und 3 mm.

Die mit Klebstoff versehenen Substratflächen werden im nächsten Schritt des erfindungsgemäßen Verfahrens bestrahlt. Diese Strahlung kann ultraviolette Strahlung sein. Es ist jedoch auch möglich, die Polymerisation durch Strahlung aus dem elektromagnetischen Spektrum zu initiieren, die sowohl sichtbare als auch ultraviolette Anteile enthält. Die Wellenläge der Strahlung liegt zweckmäßigerweise im Bereich von 200 bis 700 nm; sie kann in bevorzugten Ausführungsformen des Verfahrens auch auf den Bereich von 200 bis 600 beschränkt werden. Dabei ist es möglich, sowohl Sonnenlicht als Strahlungsquelle zu benutzen als auch irgendeine spezielle Strahlungsquelle zu verwenden, die nur Licht eines sehr engen Bereichs des elektromagnetischen Spektrums aussendet; dieser Bereich kann sowohl im ultravioletten als auch im sichtbaren Bereich liegen oder auch Bereiche sowohl des sichtbaren als auch des ultravioletten Lichtes umfassen.

In einer besonders bevorzugten Ausführungsform des erfindungsgemäßen Verfahrens stimmt man die Wellenlängenbereiche der elektromagnetischen Strahlung so mit dem in der Klebemischung enthaltenen Photoinitia tor bzw. Photosensibilisator ab, daß der Bereich der Wellenlängen im Bereich des Absorptionsmaximums des verwendeten Photoinitiators oder gegebenenfalls des verwendeten Photosensibilisators liegt. Dies geschieht in einfachster Weise dadurch, daß man den Photoinitiator bzw. Photosensibilisator, den man in die Klebemischung einarbeitet, so auswählt, daß sein Absorptionsmaximum mehr oder weniger im Wellenlängenbereich der zur Verfügung stehenden Strahlungsquelle liegt.

Ein wesentlicher Schritt des erfindungsgemäßen Verfahrens ist darin zu sehen, daß man die Polymerisation der Klebemischung bis kurz vor den Gelpunkt des Polymeren führt, ohne die mit Klebemischung versehenen Substratflächen zusammenzufügen. Für den Erfolg des Klebevorgangs des erfindungsgemäßen Verfahrens ist es also von Bedeutung, die Zeit zu bestimmen, in der an der Oberfläche des aufgetragenen Klebstoffs der Gelpunkt erreicht wird. Üblicherweise geschieht diese Gelpunktbestimmung unter denselben Bedingungen, unter denen auch der Klebevorgang erfolgt. Bevorzugterweise wird der Gelpunkt in einem dem eigentlichen Klebevorgang vorgelagerten, separaten Bestimmungsschritt für eine Klebemischung einer bestimmten Zusammensetzung bestimmt. Dies geschieht dadurch, daß man auf die später zu verklebenden Substratflächen eine Klebstoffschicht von ca. 2 bis 3 mm Dicke aufträgt und - beginnend mit dem Zeitpunkt des Auftrags - die Zeit bestimmt, innerhalb derer die Klebstoffschicht beim Berühren mit einem Holzspatel noch "Faden" des Polymeren zieht, das Polymere also noch fließen kann. Der Gelpunkt des Polymeren ist dann erreicht, wenn die Oberfläche der Klebstoffschicht beim Berühren mit dem Spatel keine Fäden mehr zieht, also nicht mehr fließt.

Die seit dem Zeitpunkt des Auftrags der Klebemischung auf die Substrate vergangene Zeit ist dann diejenige Zeit, in der der Gelpunkt des jeweiligen Polymeren erreicht wird. In dem erfindungsgemäßen Verfahren zum Kleben fester Substrate müssen die zu verklebenden und mit Klebemischung beaufschlagten Substratflächen kurz vor Erreichen des Gelpunktes, also möglichst knapp vor der vorher bestimmten Zeit, vereinigt werden; werden die Klebeflächen zu früh vereinigt, kann die Polymerisation in der Klebefuge zum Stillstand kommen. Werden die mit Klebemischung beaufschlagten Substratflächen erst nach Erreichen des Gelpunktes vereinigt, können die mit Klebemischung beschichteten Substrate meist nicht mehr verklebt werden, da die Polymerisation schon zum Abschluß gekommen ist. Werden jedoch die mit Klebemischung beaufschlagten Substratflächen kurz vor Erreichen des Gelpunktes vereinigt, lassen sich mit dem erfindungsgemäßen Verfahren zum Kleben fester Substrate optimale Klebeergebnisse erzielen. Die erhaltenen Zugscherfestigkeiten liegen - insbesondere für metallische Substrate - im Bereich bis zu 20 N . mm $^{2}$. Damit weisen sie eine deutlich höhere Festigkeit auf, als sie mit bisher bekannten Verfahren zum Kleben fester Substrate erreicht werden kann. Der besondere Vorteil des erfindungsgemäßen Verfahrens liegt jedoch darin, daß bei einer Vereinigung der mit Klebemischung beaufschlagten Substratflächen kurz vor Erreichen des Gelpunktes die verklebende Polymermischung ausgehärtet werden kann, ohne daß sie weiter bestrahlt werden muß. Es ist also möglich, die Polymerisation auch im Dunkeln der Klebefuge zu beenden, wenn man die mit Klebemischung beaufschlagten Substrate kurz vor Erreichen des Gelpunktes des Polymeren vereinigt. Dies bedeutet nichts Anderes, als daß auch Substrate miteinander verklebt werden können, die für das die Polymerisation der Klebemischung initiierende Licht nicht durchlässig sind. Insbesondere wird es mit dem erfindungsgemäßen Verfahren möglich, auch metallische Substrate miteinander zu verkleben.

Ein weiterer Vorteil des erfindungsgemäßen Verfahrens besteht darin, daß die in dem Verfahren verwendbaren Klebstoffe sogenannte "Ein-Komponenten-Systeme" sind, d.h., daß alle Komponenten der Klebesysteme zusammengemischt und in der richtigen Formulierung miteinander vereinigt werden können. Dies bringt anwendungstechnische Vorteile, die u.a. darin zu sehen sind, daß der Anwender nicht unterschiedliche Komponenten der Klebemischung kurz vor dem Klebeverfahren miteinander vermischen muß. Die in dem erfindungsgemäßen Verfahren geeigneten Klebesysteme sind lagerfähig und bedürfen nicht des Zusatzes irgendwelcher Verdickungsmittel, die häufig die Klebeeigenschaften beeinträchtigen.

Die Erfindung betrifft neben dem Varfahren zum Kleben fester Substrate auch in dem genannten Verfahren verwendbare Klebesysteme. Diese enthalten erfindungsgemäß ein oder mehrere epoxidische Monomere, einen unter Einwirkung elektromagnetischer Strahlung Protonen freisetzenden Photoinitiator und gegebenenfalls auch einen Photosensibilisator, wobei der Einsatz des letzeren besonders dann angestrebt ist, wenn für die Initiierung der Polymerisation auch Licht aus dem sichtbaren Bereich des elektromagnetischen Spektrums oder Licht verwendet werden soll, das zumindest bestimmte Bereiche des sichtbaren elektromagnetischen Spektrums umfaßt.

In den erfindungsgemäß verwendbaren Klebesystemen wird als Photoinitiator bevorzugt eine Verbindung aus der Gruppe der oben genannten Sulfoniumsalze der allgemeinen Formel (I) oder der Jodoniumsalze der allgemeinen Formel (II) verwendet. Die besonders bevorzugt verwendeten Verbindungen sind im einzelnen oben aufgeführt.

Um das eingestrahlte Licht optimal ausnutzen zu können bzw. die Energie der zur Verfügung stehenden Strahlungsquelle möglichst vollständig auf das polymerisierende System übertragen zu können, werden den erfindungsgemäßen Klebesystemen gegebenenfalls Sensibilisatoren für den sichtbaren Bereich des elektromagnetischen Spektrums zugesetzt. Wie oben beschrieben, sind dafür insbesondere Verbindungen aus der Gruppe der Acridine, Perylene und Benzoflavine geeignet. Mit Vorteil sind die Verbindungen Acridin-organe, Acridin-gelb, Benzoflavin, Setoflavin T, Phosphin R und Perylen als Photosensibilisatoren verwendbar.

Die Erfindung wird durch die nachfolgenden Beispiele näher erläutert.

Beispiel 1

Es wurde eine Klebemischung aus

(a) 79 g handelsüblichem Epoxidharz mit einem Epoxidäquivalent von 195 (modifizierter Glycidylether von Diphenylolpropan) (Epikote[R] 808),

(b) 21 g handelsüblichem Epoxidharz mit einem Epoxidäquivalent von 186 (unmodifizierter Diglycidylether von Diphenylolpropan (Epikote[R] 834),

(c) 3 g Triphenylsulfonium-hexafluoroarsenat (V) und bei Tageslicht aber unter Ausschluß von UV-Licht dadurch hergestellt, daß die einzelnen Komponenten in einem Mischer miteinander verrührt wurden. Unter Ausschluß jeglicher Belichtung wurden 0,05 g des Sensibilisators Perylen zugesetzt.

Die so hergestellte Klebemischung wurde in 2 mm dicker Schicht auf ein Eisenblech aufgetragen. Die Klebemischung wurde mit einer Osram-Ultravitalux-300 W-Lampe bestrahlt (20 cm Objektabstand). Beginnend mit dem Zeitpunkt der ersten Bestrahlung wurde die Zeit ermittelt, innerhalb derer die Polymerschicht bei Berühren mit einem Holzspatel noch Fäden zieht, d.h. noch fließfähig war. Die Zeitdauer bis zum Erreichen dieses Zustands (= Gelpunkt) war nach 210 sec erreicht.

Beispiele 2 bis 4

Entsprechend der in Beispiel 1 beschriebenen Vorgehensweise wurden folgende Klebemischungen hergestellt, wobei man jeweils 100 g der Epoxidharze nach Beispiel 1 mit wechselnden Mengen an Photoinitiator mischt. Im Beispiel 4 bestand des Epoxidharz aus gleichen Gewichtsteilen eines handelsüblichen Glycidylethers von Diphenylolpropan mit einem Epoxidäquivalent von 165 und dem Triglycidylether des Trimethylolpropans. In der nachfolgenden Tabelle 1 ist in Abhängigkeit von der laufenden Nummer des Beispiels Menge und chemische Bezeichnung des Initiators sowie die Zeit bis zum Erreichen des Gelpunktes wiedergegeben.

Tabelle 1

| Beispiel | Initiator | Gelpunkt |
|---|---|---|
| 2 | 4 g Triphenylsulfonium-hexafluoroarsenat (V) | 180 sec |
| 3 | 3 g Diphenyljodonium-hexafluorophosphat | 210 sec |
| 4 | 4 g Triphenylsulfonium-hexafluoroarsenat | 80 sec |

Beispiel 5

Die in den Beispielen 1 bis 4 hergestellten Klebemischungen wurden im Dunkeln auf entfettete und sandgestrahlte Eisenbleche mit den Abmessungen 10 cm x 2,5 cm x 0,5 cm aufgetragen; die Klebstoff-Auftragfläche betrug 2,5 $cm^2$. Die mit Klebemischung versehenen Eisenbleche wurden mit der in Beispiel 1 beschriebenen Strahlungsquelle 120 sec (Beispiele 1, 2, 3) bzw. 60 sec (Beispiel 4), d.h. bis kurz vor Erreichen des Gelpunktes bestrahlt und jeweils zwei Eisenbleche mit den mit Klebstoff versehenen Flächen aufeinandergelegt und unter leichtem Druck (etwa 1 $N/cm^2$) während 36 Stunden bei 22°C gelagert. Die Zugscherfestigkeiten wurden entsprechend den DIN-Vorschriften 53 281 und 53 283 nach 24 h ermittelt. Die Ergebnisse sind der nachfolgenden Tabelle 2 zu entnehmen.

Tabelle 2

Nach DIN 53 281/3 ermittelte Zugscherfestigkeiten (ZSF) der Verklebung von Eisenblechen

| Mischung aus Beispiel | ZSF ($N . mm^{-2}$) |
|---|---|
| 1 | 15,5 |
| 2 | 15,2 |
| 3 | 9,5 |
| 4 | 6,8 |

Ergebnis:

Wie die entsprechend DIN 53 281/3 ermittelten Zugscherfestigkeiten zeigen, erreicht die mit dem erfindungsgemäßen Verfahren erzielte Verklebung Zugscherfestigkeiten, wie sie bisher auch für transparente Substrate nicht erreicht werden konnten. Zu betonen ist außerdem, daß es sich bei den hier miteinander verklebten Eisenblechen um feste, nichttransparente Substrate handelt, bei denen die Polymerisation im Dunkeln der Klebefuge zum Abschluß gebracht wurde.

**Ansprüche**

1. Verfahren zum Kleben fester Substrate unter Verwendung von Epoxidharz, Photoinitiator und gegebenenfalls Photosensibilisator enthaltenden, nach Polymerisation klebend wirkenden Mischungen, dadurch gekennzeichnet, daß man

(a) eine Klebemischung aus

-einem oder mehreren epoxidischen Monomeren,

-einem unter Einwirkung elektromagnetischer Strahlung Protonen freisetzenden Photoinitiator und gegebenenfalls

-einem Photosensibilisator

herstellt,

(b) diese auf die zu verklebenden Substratflächen aufträgt,

(c) eine Polymerisation der Klebemischung durch Bestrahlung mit elektromagnetischer Strahlung einleitet,

(d) die zu verklebenden und mit Klebemischung beschichteten Substratflächen vereinigt und

(e) die verklebende Polymermischung aushärten läßt.

2.Verfahren nach Anspruch 1, dadurch gekennzeichnet, daß man die Polymerisation bis kurz vor den Gelpunkt des Polymeren führt.

3. Verfahren nach Ansprüchen 1 und 2, dadurch gekennzeichnet, daß man in der Klebemischung als Epoxidkomponente eine Mischung von wenigstens zwei Epoxidharzen einsetzt, wobei eine als niedermolekulare, wenigstens trifunktionelle Epoxidverbindung den Aufbau eines dreidimensionalen Netzwerkes ermöglicht.

4. Verfahren nach Ansprüchen 1 bis 3, dadurch gekennzeichnet, daß man technische Glycidylether von gegebenenfalls modifiziertem Diphenylolpropan mit einem Epoxidäquivalent im Bereich von 150 bis 300 neben Glycidylethern des Glycerins und/oder Trimethylolpropans und/oder Pentaerythrits verwendet.

5. Verfahren nach Ansprüchen 1 bis 4, dadurch gekennzeichnet, daß man eine Klebemischung verwendet, die einen unter Einwirkung elektromagnetischer Strahlung im Wellenlängenbereich von 200 bis 700 nm, bevorzugt von 200 bis 600 nm, Protonen freisetzenden Photoinitiator enthält.

6. Verfahren nach Ansprüchen 1 und 5, dadurch gekennzeichnet, daß man in der Klebemischung einen Photoinitiator aus der Gruppe der Triarylsulfoniumsalze der allgemeinen Formel (I)

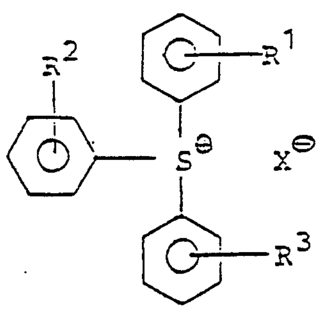

(I)

in der

$R^1$, $R^2$ und $R^3$ gleich oder verschieden sind und unabhängig voneinander für Wasserstoff, Nitro, Halogen, Oxalkyl-oder Thioalkylgruppen mit 1 bis 6 C-Atomen im geradkettigen oder verzweigten Alkylrest, Phenoxygruppen mit gegebenenfalls 1 bis 3 Substituenten am Phenylrest, Alkanoyloxy-oder Alkanoylamidoreste mit 1 bis 5 C-Atomen im Alkylrest der zugehörigen Carbonsäure stehen oder zwei der Reste $R^1$ und $R^2$ oder $R^2$ und $R^3$ als Methylen-, i-Propylen-oder Carbonylgruppe eine Brücke zwischen zwei benachbarten Phenylresten bilden, und

$X^{\ominus}$ ein halogenhaltiges komplexes Anion ist,

oder der Diaryljodoniumsalze der allgemeinen Formel (II)

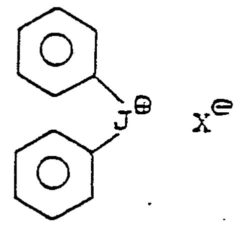

(II)

in der
$R^1$ und $R^2$ gleich oder verschieden sind und unabhängig voneinander für Wasserstoff, Nitro, Halogen, Oxalkyl-oder Thioalkylgruppen mit 1 bis 6 C-Atomen im geradkettigen oder verzweigten Alkylrest, Phenoxygruppen mit gegebenenfalls 1 bis 3 Substituenten am Phenylrest oder Alkanoyloxy-oder Alkanoylamidoreste mit 1 bis 5 C-Atomen im Alkylrest der zugehörigen Carbonsäure stehen, und
$X^\ominus$ ein halogenhaltige komplexes Anion ist,
verwendet.

7. Verfahren nach Ansprüchen 1 bis 6, dadurch gekennzeichnet, daß man in der Klebemischung einen Photoinitiator aus der Gruppe der Verbindungen der allgemeinen Formeln (I) und (II) verwendet, in denen $X^\ominus$ für ein halogenhaltiges komplexes Anion aus der Gruppe Perchlorat, Tetrafluoroborat(III), Hexachloroantimonat(V), Hexafluoroantimonat(V), Hexachlorostannat(IV), Hexafluorophosphat, Hexafluoroarsenat(V), Tetrachloroferrat(III) und Pentachlorobismutat(III) steht.

8. Verfahren nach Ansprüchen 1 bis 7, dadurch gekennzeichnet, daß man eine Klebemischung verwendet, die zusätzlich einen Sensibilisator für den sichtbaren Bereich des elektromagnetischen Spektrums enthält.

9. Verfahren nach Ansprüchen 1 bis 8, dadurch gekennzeichnet, daß man eine Klebemischung mit einem Photosensibilisator aus der Gruppe der Acridine und Perylene.

10. Verfahren nach Ansprüchen 1 bis 9, dadurch gekennzeichnet, daß man die Klebemischung auf beide Substratflächen in einer Schichtdicke im Bereich von 0,5 bis 3 mm aufträgt.

11. Klebesysteme nach Ansprüchen 1 bis 10, enthaltend als Epoxidkomponente eine Mischung von wenigstens zwei Epoxidharzen, wobei eine als niedermolekulare, wenigstens trifunktionelle Epoxidverbindung den Aufbau eines dreidimensionalen Netzwerks ermöglicht.

12. Klebesysteme nach Ansprüchen 1 bis 11, enthaltend Glycidylether von Diphenylolpropan neben Glycidylethern mehrwertiger niedermolekularer Hydroxyverbindungen.

13. Klebesysteme nach Ansprüchen 1 bis 12, enthaltend einen unter Einwirkung elektromagnetischer Strahlung im Wellenlängenbereich von 200 bis 700 nm, bevorzugt im Bereich von 200 bis 600 nm, Protonen freisetzenden Photoinitiator.

14. Klebesysteme nach Ansprüchen 1 bis 13, enthaltend einen Photosensibilisator aus der Gruppe der Acridine und Perylene.